# FASCICULE DE BREVET EUROPEEN

(11) **EP 3 839 535 B1**
(45) Date de publication et mention de la délivrance du brevet: **27.12.2023**
(21) Numéro de dépôt: 20213867.3
(22) Date de dépôt: 14.12.2020
(51) Int. Cl.: G01R 31/392

(54) **DÉTERMINATION DU VIEILLISSEMENT D'UN SYSTÈME DE STOCKAGE ÉLECTRIQUE**
BESTIMMUNG DER ALTERUNG EINES ELEKTRISCHEN SPEICHERSYSTEMS
DETERMINATION OF THE AGEING OF AN ELECTRICAL STORAGE SYSTEM

(30) Priorité: 18.12.2019 FR 1914800
(43) Date de publication de la demande: 23.06.2021
(73) Titulaire: Electricité de France, 75008 Paris (FR)
(72) Inventeur: HASCOAT, Aurélien, 77300 FONTAINEBLEAU (FR)
(74) Mandataire: Plasseraud IP

(56) Documents cités:
- EP-A2- 1 450 173
- DE-A1-102018 204 924
- FR-A1- 3 025 663
- US-A1- 2017 115 358

## Description

### Domaine technique

L'invention relève du domaine des systèmes de stockage électrique.

Plus particulièrement, l'invention porte sur des procédés de détermination d'un vieillissement d'un système de stockage électrique, des programmes informatiques destinés à mettre en oeuvre de tels procédés, des dispositifs de stockage de données stockant de tels programmes informatiques, et des circuits de traitement comprenant de tels dispositifs de stockage de données.

### Technique antérieure

A l'instar de toute batterie, le plus petit élément d'une batterie de véhicule électrique (ou de tout autre usage) est appelé cellule. La tension usuelle d'une cellule de technologie lithium-ion est habituellement comprise entre 2,5 V et 3,4 V, la moyenne de décharge se situant vers 3 V. Cette grandeur est reliée à la puissance (exprimée en W) à laquelle l'énergie peut être restituée. Plus la puissance extraite de la cellule est grande plus la valeur de la tension moyenne cellule baisse. La capacité électrique est aussi une grandeur essentielle. Cette dernière grandeur s'exprime en A.h (Ampère.heure), c'est la quantité de courant qui peut être extraite par unité de temps. La quantité d'énergie (mesurée en Wh, Watts.heure) est le produit de la capacité et de la tension restituable lors d'une décharge complète ou partielle et donc intrinsèquement elle conditionne l'autonomie d'un système batterie comme par exemple l'autonomie d'un véhicule électrique (VE).

Si l'on se place dans le domaine du véhicule électrique, plusieurs centaines de ces cellules sont assemblées de façon complexe (pack) afin de fournir au moteur électrique une puissance suffisante pour mouvoir le véhicule (assemblage en série) et pour garantir au VE une autonomie acceptable (assemblage en parallèle).

Les systèmes de stockage d'énergie électrochimiques voient leurs performances s'amenuiser naturellement au fil de leur utilisation (vieillissement dit par cyclage) ou même en dehors de leur utilisation (vieillissement dit calendaire). Pour les VE, ces vieillissements dépendent par exemple des cellules utilisées, de l'usage du VE, du climat, du lieu de garage, et même de la couleur du véhicule qui a une incidence sur la température de celui-ci... Il est connu, du document EP1450173, de déterminer une caractéristique de vieillissement d'une batterie au moyen de cycles de chargement et de déchargement. D'autres documents pertinents pour l'état de l'art sont US 2017/115358 A1, FR 3 025 663 A1 et DE 10 2018 204924 A1.

Cet état de fait a conduit à définir une variable appelée « état de santé » ou SOH (State Of Health). Sans unité, elle est définie comme le rapport entre l'énergie électrique réelle et l'énergie électrique nominale.

Ainsi pour un système neuf, l'énergie électrique réelle équivaut à l'énergie nominale. Le SOH est de 100 %. Pour les VE, cette perte progressive a pour conséquence une perte d'autonomie progressive et peu contrôlable (moyennement prédictible). Lorsque l'autonomie devient inacceptable pour l'automobiliste (SOH de 75 % Pour la Zoé de Renault), une nouvelle batterie est installée à bord du véhicule tandis que l'ancienne est destinée à être recyclée sous différentes formes (démontage, récupération de parties, brûlage et récupération des métaux).

Une étape du recyclage pouvant être avantageuse est d'envisager une réutilisation de ces systèmes dans les domaines pour lesquelles cette baisse de performance n'est pas rédhibitoire ; deuxième vie à bord de VE déclassés en autonomie ou stockage stationnaire vers des applications du réseau électrique pour faire par exemple une association avec des productions photovoltaïques intermittentes non prédictibles).

Une telle deuxième vie présente un attrait économique à la fois par rapport aux prix de marché du neuf au moment de l'achat et tout au long de la seconde vie. Cette réutilisation s'inscrit dans l'objectif de l'Union Européenne de construire une économie circulaire.

L'utilisation de tels systèmes n'est envisageable que si la sécurité, les performances et les durées de vie sont satisfaisantes et suffisamment prédictibles. La mesure de SOH d'une batterie est donc un élément clef pour rejoindre une utilisation secondaire. La difficulté technique est d'évaluer ces critères avec des batteries usagées ayant subi des contraintes d'utilisation inconnues durant plusieurs années. A cela s'ajoute une hétérogénéité de ces performances au niveau même des cellules et de façon inévitable, une hétérogénéité d'un pack à l'autre, à fortiori avec des conditions d'utilisation différentes.

Nous nous intéressons spécifiquement à la réutilisation de batteries de véhicules électriques usagées. En pratique, les entreprises qui possèdent les batteries soit les recyclent elles-mêmes, soit les vendent à des Tiers. Mais elles demeurent juridiquement responsables de ces batteries, même après la vente à des Tiers et ce jusqu'à leur destruction ou recyclage. Une façon de valoriser ces batteries usagées consiste à les utiliser en conservant leur intégrité (pas de démontage des éléments de la batterie une fois celle-ci retirée du véhicule) pour produire de nouveaux systèmes de stockage.

La détermination de l'état de santé d'une batterie ou d'une cellule est donc un point bloquant. Il n'existe aujourd'hui qu'une seule mesure capable de déterminer cette propriété cruciale. Cette mesure consiste en la décharge totale de la batterie ou de la cellule pour en mesurer l'énergie ou la capacité. A défaut, des modèles de prédiction du vieillissement sont utilisés.

Dans le cas d'une réutilisation de batteries en seconde vie vers des systèmes stationnaires, deux pratiques sont répandues.

La première pratique consiste à démanteler les packs afin d'évaluer la qualité de chaque cellule. Ce cas est possible quand l'entreprise qui possède initialement les batteries les recycle elle-même. Celles-ci sont caractérisées puis triées selon un nombre important de paramètres. Cette solution demande beaucoup de temps, de moyens de caractérisation et oblige à réaliser une nouvelle intégration (électronique, soudures, boitier,...). Il est alors possible de réaliser des réassemblages homogènes de cellules ayant des niveaux de qualités acceptables.

L'autre pratique consiste à produire des batteries de seconde vie à partir de packs usagés soit sans avoir aucune idée de l'état de santé des packs soit en ayant une estimation tirée de modèles conçus uniquement pour approximer l'état de santé lors de l'utilisation embarquée en VE. Dans le cadre d'une cession de ces batteries à une société tierce, la cession des données et des modèles est difficilement envisageable pour des raisons évidentes de secret industriel. De plus les modèles de prédiction du constructeur de VE ne correspondraient pas aux conditions de vies nouvelles des batteries en usage stationnaire. Pour ces systèmes à intégrité conservée, il n'est en outre pas possible de réaliser la décharge complète du système, même de façon exceptionnelle. Cette possibilité est interdite par le système de gestion de la batterie à des fins d'optimisation de la durée de vie durant l'utilisation dans un VE. En effet, les constructeurs de véhicules électriques ont limité la fenêtre de charge généralement entre un état de charge bas et un état de charge haut (par exemple entre 20% et 80%), afin d'être assuré d'une durée de vie plus longue des batteries. Ainsi il est impossible de décharger complètement les batteries.

Les nouvelles conditions d'utilisation pouvant être très différentes de celles rencontrées lors d'un usage type VE en termes de température, courant électrique et fenêtre de cyclage, la prédiction du vieillissement de ce système est d'autant plus complexe et représente un problème car elle rend risquée toute tentative d'utilisation en seconde vie à grande échelle.

Il existe donc un besoin d'évaluer rapidement, simplement et avec fiabilité le vieillissement d'un système de stockage électrique formé d'une ou de plusieurs batteries, de manière agnostique d'une précédente vie de la ou des batteries.

### Résumé

La présente divulgation vient améliorer la situation.

Un aspect de l'invention porte sur un procédé selon la revendication 1.

Un autre aspect de l'invention porte sur un programme informatique comportant des instructions pour la mise en oeuvre du procédé décrit ci-avant lorsque ce programme est exécuté par un processeur.

Un autre aspect de l'invention porte sur un support d'enregistrement non transitoire lisible par un ordinateur sur lequel est enregistré un programme pour la mise en oeuvre du procédé décrit ci-avant lorsque ce programme est exécuté par un processeur.

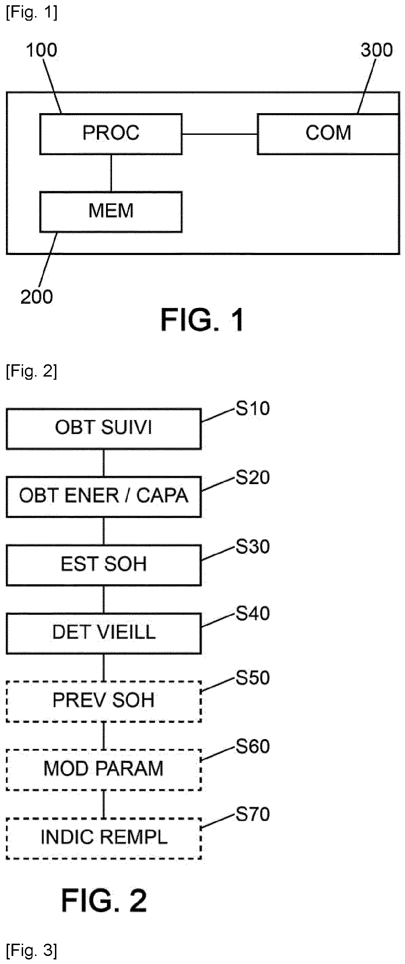

Un autre aspect de l'invention, tel qu'illustré sur la [Fig. 2], porte sur un circuit de traitement comprenant un processeur PROC (100) connecté à un support d'enregistrement non transitoire MEM (200) décrit ci-avant. Un tel circuit de traitement peut par exemple comprendre une interface de communication COM (300) avec un dispositif de commande du système de stockage électrique.

Grâce au suivi de l'état de charge de la batterie qui est relevé à compter de l'instant d'utilisation, par exemple au cours du fonctionnement usuel d'une batterie en deuxième vie, il est possible d'en évaluer au cours du temps l'évolution de l'état de santé.

Sur la base de cette évaluation, il est possible de déterminer le vieillissement d'une batterie utilisée dans un système de stockage électrique de manière agnostique de toute utilisation précédente de la batterie antérieure à l'instant d'utilisation et à la mise en place du suivi de l'état de charge.

Grâce à la possibilité de mettre en oeuvre le procédé de l'invention durant la nouvelle exploitation de batteries, il n'est pas nécessaire de caractériser ces batteries, ou les cellules les constituant, après leur première vie et avant de les consacrer à cette nouvelle exploitation.

Le gain de temps résultant de la détermination du vieillissement d'une batterie en cours d'utilisation facilite la réutilisation à grande échelle de batteries usagées conçues par exemple pour des véhicules électriques. En particulier, la réutilisation dans des systèmes de stockage électrique stationnaires est facilitée.

Dans un mode de réalisation, la batterie a été précédemment utilisée montée dans un véhicule électrique.

De telles batteries ne peuvent pas être totalement chargées ou déchargées en raison de limitations imposées lors de leur conception. Or, comme indiqué précédemment, l'état de la santé d'une batterie est déterminé par référence sur la base du suivi d'une charge ou d'une décharge complète. Grâce au suivi de l'état de charge de la batterie comprenant une alternance de sollicitations en charge et en décharge, il est possible de déterminer le vieillissement d'une batterie y compris si celle-ci a précédemment été utilisée montée dans un véhicule électrique, donc même si celle-ci ne peut être totalement chargée ou déchargée.

Dans un mode de réalisation, estimer les états de santé comprend :
- identifier, dans le suivi obtenu, une pluralité de sollicitations correspondant à un même profil type de sollicitation, et
- estimer l'état de santé de la batterie pour chaque sollicitation identifiée.

Ainsi, les estimations d'état de santé de la batterie sont reproductibles et directement comparables entre elles.

Un système de stockage électrique se chargeant automatiquement en heures creuses permet d'obtenir naturellement, au cours de l'utilisation normale du système, des sollicitations en charge correspondant à un même profil type.

Les sollicitations en charge d'un système de stockage électrique se chargeant préférentiellement au moyen d'énergie collectée par un panneau solaire peuvent varier en fonction de l'ensoleillement. Des sollicitations correspondant à un profil type peuvent être provoquées en tant que de besoin de manière répétée ou périodique pour garantir une estimation répétée ou périodique de l'état de santé de la batterie.

Dans un mode de réalisation, l'intervalle de temps est compris entre un mois et un an.

Un intervalle d'un mois permet de disposer d'un nombre suffisamment important d'estimation d'états de santé de la batterie pour déterminer, avec une précision statistique acceptable, le vieillissement de la batterie.

Toutefois, une telle détermination nécessite soit :
- de faire abstraction de la variabilité de paramètres extérieurs ayant un effet sur le vieillissement de la batterie telle que la variation de température en fonction des saisons, ou
- d'introduire une correction de l'estimation du vieillissement en fonction de ces paramètres extérieurs qui peuvent être par exemple relevés séparément ou prédits.

Un intervalle d'un an est idéal pour estimer le vieillissement d'une batterie compte tenu de la variabilité de ces conditions extérieures.

Dans le mode de réalisation proposé, l'alternance d'une sollicitation en charge et d'une sollicitation en décharge formant un cyclage :
- chaque état de santé estimé lors d'une sollicitation est associé à un nombre de cyclages effectués, au cours de l'intervalle de temps, avant ladite sollicitation, et
- déterminer, sur la base des états de santé estimés, un vieillissement de la batterie comprend déterminer une indication d'un nombre de cyclages effectués préalablement à l'intervalle de temps par la batterie.

Ainsi, il est possible de déterminer le nombre de cyclages subies par la batterie depuis sa première utilisation. Sur la base de ce nombre de charges, il est possible de prédire par exemple une durée de vie restante de la batterie en termes de temps restant et/ou de nombre de cyclages restants. Cette prédiction peut permettre par exemple à l'utilisateur de commander par anticipation une nouvelle batterie de remplacement.

Dans un mode de réalisation :
- chaque état de santé estimé lors d'une sollicitation est associé à une date de ladite sollicitation, et
- déterminer, sur la base des états de santé estimés, un vieillissement de la batterie comprend déterminer une indication d'un vieillissement calendaire de la batterie.

La détermination du vieillissement d'une batterie peut être exploitée de différentes manières.

Dans un mode de réalisation, le procédé comprend en outre :
- prévoir l'évolution de l'état de santé de la batterie sur la base du vieillissement déterminé.

Estimer le vieillissement de la batterie permet en effet de prédire le rythme de la dégradation ultérieure de l'état de santé de la batterie.

Le degré de certitude de la prédiction est particulièrement élevé lorsqu'à la fois le vieillissement calendaire et le vieillissement lié au cyclage sont déterminés.

En effet, le vieillissement calendaire et le vieillissament lié au cyclage influent à des rythmes différents sur la dégradation ultérieure de l'état de santé de la batterie.

Cette prédiction peut être effectuée par exemple à l'aide par exemple d'un modèle prédictif, par extrapolation de l'état de santé couramment estimé de la batterie et compte tenu du vieillissement déterminé.

Dans un mode de réalisation, le procédé comprend en outre :
- modifier un paramètre de fonctionnement de la batterie sur la base du vieillissement déterminé.

Par exemple, il peut être prévu de choisir un mode de fonctionnement du système de stockage d'énergie parmi plusieurs modes de fonctionnement possibles, sur la base du vieillissement de la batterie ou d'une prédiction d'un état de santé ultérieur de la batterie.

En effet, si la durée de vie restante prédite de la batterie est suffisamment importante ou si le vieillissement de la batterie est en-deçà d'un certain seuil, il peut être prévu d'augmenter la différence entre la limite supérieure d'état de charge et la limite inférieure d'état de charge formant la fenêtre de cyclage.

Augmenter la taille de la fenêtre de cyclage a pour effet de maximiser l'autonomie de la batterie. Ainsi, la batterie est exploitée de manière à fournir des performances optimales.

Si en revanche la durée de vie restante prédite de la batterie est inférieure à un seuil prédéterminé ou si le vieillissement de la batterie est au-delà d'un seuil prédéterminé, il peut être prévu de réduire la différence entre la limite supérieure d'état de charge et la limite inférieure d'état de charge formant la fenêtre de cyclage.

Réduire la taille de la fenêtre de cyclage a pour effet de prolonger la durée de vie restante de la batterie par rapport à la valeur prédite. Ainsi, lorsque la batterie est en fin de vie, son exploitation peut correspondre à un mode de fonctionnement permettant d'en retarder le remplacement.

Dans un mode de réalisation, le procédé comprend en outre :
- déterminer un besoin de remplacer la batterie sur la base du vieillissement déterminé.

En effet, le vieillissement de la batterie ou la prédiction de l'état de santé de la batterie peuvent être utilisés pour estimer un délai restant avant remplacement de la batterie ou un nombre de cyclages restants avant remplacement de la batterie. De telles estimations peuvent donner lieu à une alerte à destination de l'utilisateur ou du fournisseur du système de stockage et peuvent par exemple donner lieu à une commande, éventuellement automatique, d'une batterie de remplacement.

### Brève description des dessins

D'autres caractéristiques, détails et avantages apparaîtront à la lecture de la description détaillée ci-après, et à l'analyse des dessins annexés, sur lesquels :
**Fig. 1**
   La [Fig. 1] illustre schématiquement la structure d'un circuit de traitement, dans un exemple de réalisation, pour la mise en oeuvre du procédé proposé.
**Fig. 2**
   La [Fig. 2] est un ordinogramme d'un algorithme général d'un programme informatique, dans un exemple de réalisation, pour la mise en oeuvre du procédé proposé.
**Fig. 3**

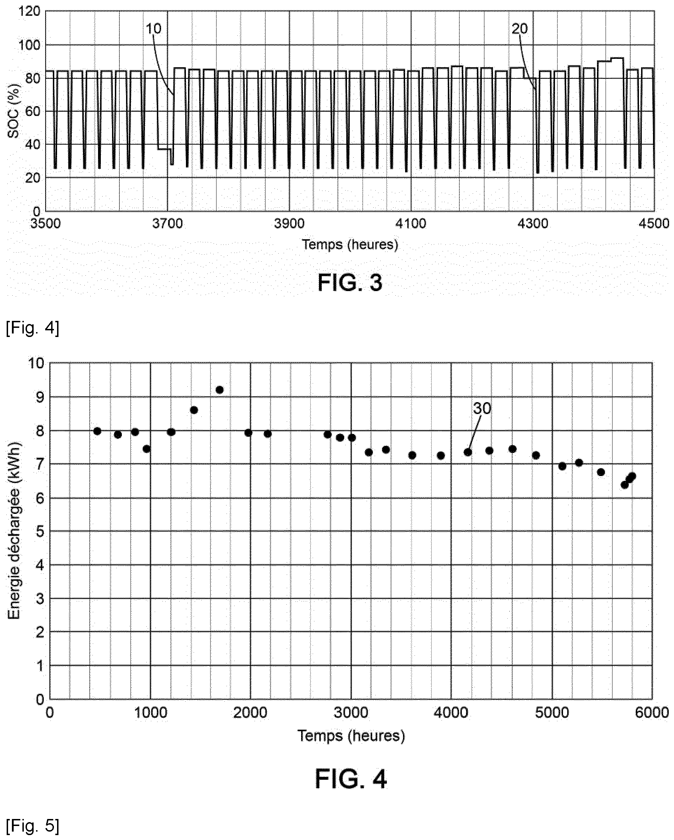

   La [Fig. 3] est un exemple de suivi de l'état de charge d'une batterie au cours d'un intervalle de 1000 heures, entre 3500 et 4500 heures d'exploitation,.
**Fig. 4**
   La [Fig. 4] représente, pour une pluralité de décharges d'une batterie, une intégration de la puissance déchargée au cours de chaque décharge.
**Fig. 5**

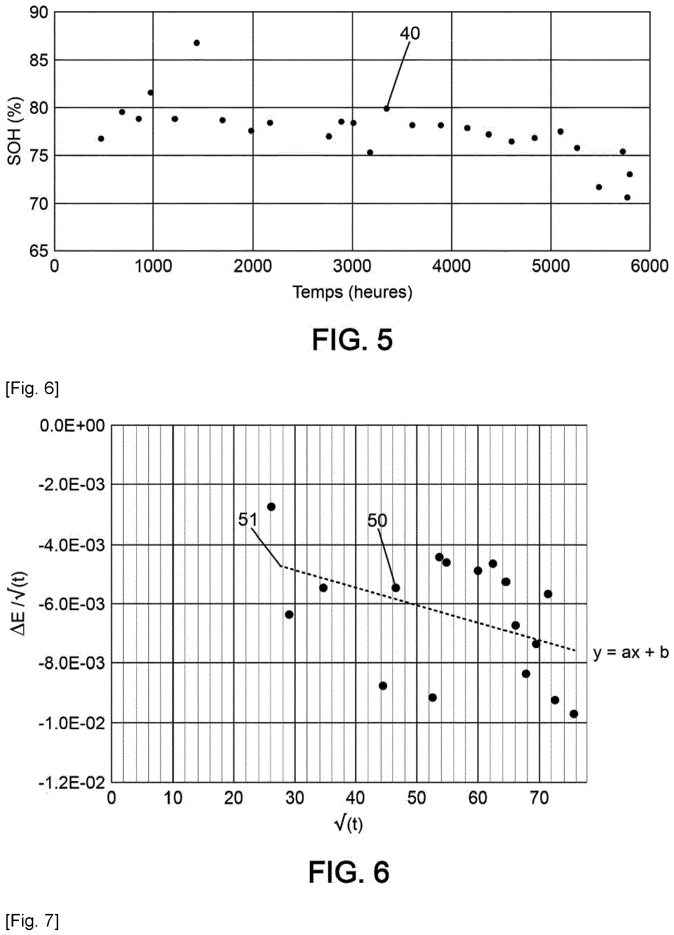

   La [Fig. 5] illustre une estimation de l'évolution de l'état de santé d'une batterie au cours de son exploitation, dans un mode de réalisation de l'invention.
**Fig. 6**
   La [Fig. 6] illustre une linéarisation, conformément à un modèle prédictif de vieillissement dans un mode de réalisation de l'invention, de l'évolution de l'état de santé d'une batterie au cours de son exploitation représenté sur la [Fig. 5].
**Fig. 7**

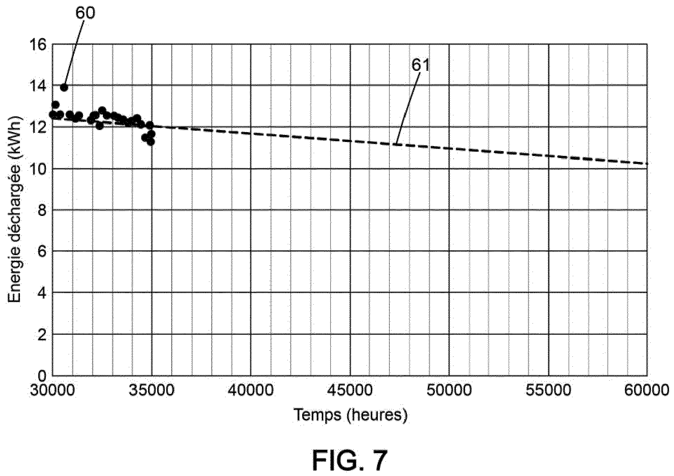

   La [Fig. 7] illustre une modélisation prédictive de la dégradation d'un système de stockage électrique dans un mode de réalisation de l'invention, et la comparaison de cette modélisation prédictive à des états de santé estimés.

### Description des modes de réalisation

On considère un système de stockage électrique comprenant une ou plusieurs batteries. Chaque batterie est un élément de stockage électrique. Une batterie peut ici désigner n'importe quel type d'accumulateur électrochimique. Les accumulateurs électrochimiques les plus répandus sont de type lithium-ion. Différentes chimies de lithium ion telles que NMC, LMO, LFP peuvent être envisagées, de même que des accumulateurs électrochimiques sans lithium-ion telles que les batteries à électrolyte solide.

On se réfère à présent à la [Fig. 2], qui illustre un exemple d'algorithme général d'un programme informatique pour la mise en oeuvre d'un exemple de mode de réalisation du procédé proposé.

Le mode de réalisation proposé permet de déterminer et de prévoir l'état de santé d'un système de stockage stationnaire en seconde vie constitué d'une ou de plusieurs batteries issues de véhicules électriques (batterie non démantelée pour la réutilisation) en s'affranchissant des données et modèles acquis et utilisés durant la première vie.

Un suivi de données d'exploitation du système de stockage d'énergie est obtenu OBT SUIVI (S10) lors de cyclages partiels.

Un exemple de cyclage partiel est une décharge ou une charge dans une fenêtre de cyclage délimitée par une borne maximale d'état de charge (par exemple 80%) et une borne minimale d'état de charge (par exemple 20 %).

Le profil de la charge ou de la décharge peut être défini à l'avance ou peut répondre à un besoin d'exploitation. Pour une durée représentative du nouvel usage et du vieillissement (de quelques mois à un an), le système de stockage d'énergie fonctionne soit normalement, soit en introduisant de façon régulière un profil type de sollicitation (charge ou décharge entre les bornes minimales et maximale de façon monotone, si possible à courant constant et même conditions de température).

Une donnée d'exploitation comprend un état de charge de la batterie en fonction du temps et peut comprendre une variation en fonction du temps d'autres grandeurs électriques caractérisant un transfert d'énergie électrique de ou vers le système de stockage d'énergie, ou plus particulièrement de ou vers une batterie du système de stockage d'énergie.

Une telle grandeur électrique peut être une tension électrique, un courant électrique, une puissance électrique, une impédance, etc.

Pour avoir une bonne précision, la durée d'acquisition peut varier. Par exemple, pour du stockage d'énergie solaire en France métropolitaine, il est préférable de réaliser l'acquisition durant une année entière afin d'intégrer les effets liés au cycle des saisons. A défaut, choisir une période d'acquisition durant le printemps ou l'automne. D'autres dispositions peuvent être prises en fonction de l'emplacement géographique et du climat.

Un exemple de suivi de données d'exploitation d'une telle batterie est présenté dans la [Fig. 3] sous la forme d'un état de charge en fonction du temps. Le profil est très reproductible et découle d'un usage stationnaire dit « résidentiel ». Le système de stockage électrique se charge en journée via des panneaux solaires puis se décharge selon la demande. Chaque charge 10 est représentée par une augmentation de l'état de charge. Chaque décharge 20 est représentée par une diminution de l'état de charge.

On se réfère à présent à la [Fig. 4] qui représente, pour une pluralité de décharges d'une batterie, une intégration de la puissance déchargée au cours de chaque décharge. Cette intégration est effectuée à partir du suivi d'état de charge obtenu en fonction du temps représenté sur la [Fig. 3].

L'intégration de la puissance lors des décharges (ou charges) permet, pour chaque sollicitation, de déterminer l'énergie 30 échangée au cours de ladite sollicitation. Alternativement, il est possible d'intégrer le courant au cours de chaque charge ou décharge, ce qui permet de déterminer la capacité échangée pour chaque cycle.

De manière générale, intégrer la puissance ou le courant au cours d'une charge ou d'une décharge permet d'obtenir OBT ENER / CAPA (S20) l'énergie ou la capacité échangée pour chaque cycle et de suivre cette évolution au cours de la durée d'exploitation.

Toute l'énergie électrique contenue dans chaque batterie n'est pas utilisée lors de chaque charge ou décharge partielle. Cependant, même si la sollicitation n'est que partielle, l'intégralité de la batterie vieillit. Les énergies et les capacités obtenues peuvent être corrigées, par exemple par application d'une loi de proportionnalité, de manière à exprimer chaque cyclage partiel effectué en tant qu'équivalent à une fraction d'un cyclage complet.

Il peut ainsi être considéré par exemple que l'énergie E(ech i-j) échangée au cours d'un cyclage entre un premier état de charge i et un deuxième état de charge j, où i et j sont exprimés en pourcentage, est proportionnelle à |i-j| (le module de la différence entre i et j).

En utilisant la même loi de proportionnalité que ci-dessus, il est possible de calculer, à partir d'une capacité échangée au cours d'un cyclage partiel entre le premier état de charge i et le deuxième état de charge j, quelle aurait été la capacité qui aurait été échangée si le cyclage avait été réalisé entre 100 % et 0 % d'état de charge.

L'énergie ou la capacité échangée au cours d'un cyclage partiel donné entre le premier état de charge i et le deuxième état de charge j est maximale lorsque l'état de santé (SOH) de la batterie est de 100%.

Au cours du temps, l'état de santé de la batterie diminue. En répétant au cours du temps un cyclage partiel identique, une perte d'énergie (ΔE) et une perte de capacité (ΔC) échangée est constatée.

Pour une pluralité de cyclages partiels, sur la base de l'énergie ou de la capacité échangée au cours du cyclage, l'état de santé SOH 40 de la batterie est estimé EST SOH (S30).

On se réfère à présent à la [Fig. 5] qui représente, pour une pluralité de décharges d'une batterie, l'état de santé SOH 40 de la batterie. L'état de santé est ici déterminé sur la base de l'énergie échangée lors de chaque décharge.

L'état de santé SOH 40 peut être obtenu en divisant l'énergie (ou la capacité) échangée au cours d'un cyclage partiel par l'énergie (ou la capacité) qui aurait été échangée au cours du même cyclage partiel par une batterie ayant un état de santé de 100%.

Alternativement, l'état de santé SOH est obtenu à partir de l'énergie (ou de la capacité) échangée au cours d'un cyclage partiel :
- en déterminant l'énergie (ou la capacité) qui aurait été échangée si le cyclage avait été complet, donc réalisé entre 100 % et 0 % d'état de charge, et
- en divisant l'énergie (ou la capacité) ainsi déterminée par l'énergie (ou la capacité) nominale échangée par une batterie ayant un état de santé de 100% au cours d'un cyclage réalisé entre 100% et 0% d'état de charge.

L'énergie et la capacité nominales sont généralement connues et fournies par le fabricant de la batterie.

Les états de santé estimés au cours du temps pour une pluralité de sollicitations de la batterie sont mémorisés et sur la base des états de santé mémorisés, un vieillissement de la batterie est déterminé DET VIEILL (S40).

Il existe de nombreux modèles permettant de décrire et de prédire des vieillissements.

Dans le mode de réalisation présenté, le modèle utilisé est un modèle connu de type fatigue. Celui-ci relie les sollicitations endurées par les batteries (température, courant, état de charge) aux dommages provoqués par ces sollicitations qui s'ajoutent avec le temps d'utilisation.

Ce modèle de vieillissement prédictif permet de prendre en compte l'ensemble des nouvelles conditions d'usage de la batterie de seconde vie.

Ce modèle considère que les pertes d'énergie (ΔE) liées au vieillissement calendaire et au vieillissement lié au cyclage se cumulent selon l'expression Δ*E* = *k_cyclage* * *t* + *k_calendaire* * *√t* . L'équation du modèle peut être résolue par linéarisation des données en considérant une droite ayant pour équation *ΔE*/*√t* = *k_cyclage* * √*t* + *k_calendaire.*

Comme le montre la Figure 6, les paramètres sont alors déduits graphiquement par une représentation graphique 51 de Δ*E*/√*t* en fonction de √*t*, superposée aux valeurs calculées 50 de Δ*E*/*√t* où :
- a est la valeur de la pente, égale à k_cyclage, et
- b est la valeur de l'ordonnée à l'origine, égale à k_calendaire.

Ainsi, le modèle permet de découpler l'influence du vieillissement lié au cyclage et du vieillissement calendaire sur l'état de santé de la batterie.

Il est possible, à partir du vieillissement déterminé, de prévoir PREV SOH (S50) l'évolution de l'état de santé de la batterie.

Sur la [Fig. 7], les prévisions 61 d'évolution d'état de santé d'une batterie en fonction du temps sur un intervalle de 30 000 heures sont représentées en pointillés, superposées avec les mesures 60 d'état de santé de la batterie sur un intervalle de 5 000 heures.

Ainsi, en s'appuyant sur les services rendus par un système de stockage électrique comprenant une ou plusieurs batteries, il est possible de suivre et de prévoir l'évolution de l'état de santé du système de stockage sans connaître l'historique de la première vie des batteries.

Disposer à la fois d'une indication du vieillissement lié au cyclage et d'une indication du vieillissement calendaire permet de prévoir avec une meilleure précision l'évolution de l'état de santé de la batterie en fonction des parts respectives du vieillissement calendaire et du vieillissement lié au cyclage à la fois au cours de la ou des utilisations précédentes de la batterie et au cours de son utilisation ultérieurement prévue.

A partir de l'évolution prévue de l'état de santé de la batterie, il est alors possible de redéfinir MOD PARAM (S60) les paramètres d'exploitation pour optimiser les services rendus par la batterie ainsi que sa durée de vie, par exemple en fonction de la garantie adjointe au système.

Il est également possible de prévoir les maintenances nécessaires au système et notamment d'indiquer INDIC REMPL (S70) une nécessité de remplacer la batterie. Pouvoir fournir une telle indication est un moteur au développement commercial d'une réutilisation en seconde vie de batteries de véhicules électriques.

## Revendications

1. Procédé de détermination d'un vieillissement d'au moins une batterie utilisée dans un système de stockage électrique et ayant un état de charge variable au sein d'une fenêtre de cyclage formant une partie d'un domaine nominal de fonctionnement, le procédé comprenant, pour la ou chaque batterie :
- obtenir (S10), à partir d'un instant d'utilisation de la batterie, un suivi d'une grandeur relative à la batterie en fonction du temps au cours d'un intervalle de temps commençant audit instant, le suivi comprenant une alternance de sollicitations en charge (10) et en décharge (20) au sein de la fenêtre de cyclage,
- pour une pluralité de sollicitations au cours de l'intervalle de temps, obtenir (S20) une valeur d'une grandeur électrique indicative d'une énergie (30) échangée par la batterie lors de ladite sollicitation et estimer (S30) un état de santé (40) de la batterie lors de ladite sollicitation sur la base de ladite valeur, et
- déterminer (S40), sur la base des états de santé estimés, un vieillissement de la batterie,
**caractérisé en ce que** :
- la grandeur relative à la batterie est un état de charge de la batterie, et
l'alternance d'une sollicitation en charge et d'une sollicitation en décharge formant un cyclage :
- chaque état de santé estimé lors d'une sollicitation est associé à un nombre de cyclages effectués, au cours de l'intervalle de temps, avant ladite sollicitation, et
- la détermination, sur la base des états de santé estimés, d'un vieillissement de la batterie comprend la détermination d'une indication d'un nombre de cyclages effectués préalablement à l'intervalle de temps par la batterie.

2. Procédé selon la revendication 1, dans lequel :
- chaque état de santé estimé lors d'une sollicitation est associé à une date de ladite sollicitation, et
- la détermination, sur la base des états de santé estimés, d'un vieillissement de la batterie comprend la détermination d'une indication d'un vieillissement calendaire de la batterie.

3. Procédé selon l'une des revendications précédentes, dans lequel la batterie a été précédemment utilisée montée dans un véhicule électrique.

4. Procédé selon l'une des revendications précédentes, comprenant :
- prévoir (S50) l'évolution de l'état de santé de la batterie sur la base du vieillissement déterminé.

5. Procédé selon l'une des revendications précédentes, comprenant :
- modifier (S60) un paramètre de fonctionnement de la batterie sur la base du vieillissement déterminé.

6. Procédé selon l'une des revendications précédentes, comprenant :
- déterminer (S70) un besoin de remplacer la batterie sur la base du vieillissement déterminé.

7. Procédé selon l'une des revendications précédentes, dans lequel l'intervalle de temps est compris entre un mois et un an.

8. Procédé selon l'une des revendications précédentes, dans lequel estimer (S30) les états de santé comprend :
- identifier, dans le suivi obtenu, une pluralité de sollicitations correspondant à un même profil type de sollicitation, et
- estimer l'état de santé de la batterie pour chaque sollicitation identifiée.

9. Programme informatique comportant des instructions pour la mise en oeuvre du procédé selon l'une des revendications 1 à 8 lorsque ce programme est exécuté par un processeur.

10. Support d'enregistrement non transitoire lisible par un ordinateur sur lequel est enregistré un programme pour la mise en oeuvre du procédé selon l'une des revendications 1 à 8 lorsque ce programme est exécuté par un processeur.

11. Circuit de traitement comprenant un processeur (100) connecté à un support d'enregistrement non transitoire (200) selon la revendication 10.

## Patentansprüche

1. Verfahren zur Bestimmung der Alterung wenigstens einer Batterie, die in einem elektrischen Speichersystem verwendet wird und einen variablen Ladezustand innerhalb eines Zyklenfensters hat, das einen Teil eines nominalen Betriebsbereichs bildet, wobei das Verfahren für die oder jede Batterie umfasst:
- ausgehend von einem Verwendungszeitpunkt der Batterie, Erhalten (S10) einer Verfolgung einer auf die Batterie bezogenen Größe als Funktion der Zeit während eines Zeitintervalls, das mit dem Zeitpunkt beginnt, wobei die Verfolgung eine Abwechslung von Beaufschlagungen beim Laden (10) und beim Entladen (20) innerhalb des Zyklenfensters umfasst,
- für eine Vielzahl von Beaufschlagungen während des Zeitintervalls, Erhalten (S20) eines Wertes einer elektrischen Größe, die eine von der Batterie während der Beaufschlagung ausgetauschte Energie (30) anzeigt, und Schätzen (S30) eines Gesundheitszustands (40) der Batterie während der Beaufschlagung auf der Grundlage des Wertes, und
- auf der Grundlage des geschätzten Gesundheitszustands Bestimmen (S40) einer Alterung der Batterie,
**dadurch gekennzeichnet, dass:**
- die Größe, die sich auf die Batterie bezieht, ein Ladezustand der Batterie ist, und der Wechsel zwischen einer Beaufschlagung beim Laden und einer Beaufschlagung beim Entladen Zyklen bildet:
- jeder bei einer Beaufschlagung geschätzte Gesundheitszustand einer Anzahl von Zyklen zugeordnet ist, die in dem Zeitintervall vor der Beaufschlagung durchgeführt wurden, und
- die auf der Grundlage der geschätzten Gesundheitszustände, bestimmte Alterung der Batterie die Bestimmung eines Hinweises auf eine Anzahl von Zyklen umfasst, die vor dem Zeitintervall durch die Batterie durchgeführt wurden.

2. Verfahren nach Anspruch 1, wobei:
- jeder bei einer Beaufschlagung geschätzte Gesundheitszustand einem Datum der Beaufschlagung zugeordnet wird, und
- die Bestimmung einer Alterung der Batterie auf der Grundlage der geschätzten Gesundheitszustände die Bestimmung eines Hinweises auf eine kalendarische Alterung der Batterie umfasst.

3. Verfahren nach einem der vorhergehenden Ansprüche, wobei die Batterie zuvor in einem Elektrofahrzeug eingebaut verwendet wurde.

4. Verfahren nach einem der vorhergehenden Ansprüche, umfassend:
- Vorhersagen (S50) der Veränderung des Gesundheitszustands der Batterie auf der Grundlage der bestimmten Alterung.

5. Verfahren nach einem der vorhergehenden Ansprüche, umfassend:
- Modifizieren (S60) eines Betriebsparameters der Batterie auf der Grundlage der bestimmten Alterung.

6. Verfahren nach einem der vorhergehenden Ansprüche, umfassend:
- Bestimmen (S70) einer Notwendigkeit, die Batterie auf der Grundlage der bestimmten Alterung zu ersetzen.

7. Verfahren nach einem der vorhergehenden Ansprüche, wobei das Zeitintervall zwischen einem Monat und einem Jahr liegt.

8. Verfahren nach einem der vorhergehenden Ansprüche, wobei das Schätzen (S30) der Gesundheitszustände umfasst:
- Identifizieren einer Vielzahl von Beaufschlagungen, die demselben typischen Beaufschlagungsprofil entsprechen, in der erhaltenen Verfolgung, und
- Schätzen des Gesundheitszustands der Batterie für jede identifizierte Beaufschlagung.

9. Computerprogramm, umfassend Anweisungen zur Durchführung des Verfahrens nach einem der Ansprüche 1 bis 8, wenn das Programm von einem Prozessor ausgeführt wird.

10. Computerlesbares, nicht transitorisches Aufzeichnungsmedium, auf dem ein Programm zur Durchführung des Verfahrens nach einem der Ansprüche 1 bis 8 aufgezeichnet ist, wenn dieses Programm von einem Prozessor ausgeführt wird.

11. Verarbeitungsschaltung, umfassend einen Prozessor (100), der mit einem nichttransitorischen Aufzeichnungsmedium (200) nach Anspruch 10 verbunden ist.

## Claims

1. A method for determining an aging of at least one battery used in an electric storage system and having a variable state of charge within a cycling window forming a portion of a nominal operating domain, where the method comprises, for the or each battery:
- getting (S10), from at least one moment of use of the battery, a tracking of a quantity relative to the battery as a function of time over an interval of time starting at said moment, where the tracking comprises an alternation of calls for charging (10) and discharging (20) within the cycling window;
- for a plurality of calls over the time interval, getting (S20) a value of an electric quantity indicative of energy (30) exchanged by the battery during said call and estimating (S30) a state of health (40) of the battery during said call based on said value; and
- determining (S40) an aging of the battery, on the basis of the estimated states of health,
**characterized in that**:
- the quantity relative to the battery is a state of charge of the battery, and
the alternation of a call for charging and a call for discharging forming a cycle:
- each state of health estimated during a call is associated with a number of cycles done, during the time interval, before said call; and
- determining, on the basis of the estimated states of health, an aging of the battery comprises determining an indication of a number of cycles done by the battery previous to the time interval.

2. The method according to claim 1, wherein:
- each state of health estimated during a call is associated with a date of said call, and
- on the basis of the estimated state of health, determining an aging of the battery comprises determining an indication of a calendar aging of the battery.

3. The method according to one of the preceding claims, wherein the battery was previously used mounted in an electric vehicle.

4. The method according to one of the preceding claims, comprising:
- anticipating (S50) the progression of the state of health of the battery on the basis of the determined aging.

5. The method according to one of the preceding claims, comprising:
- modifying (S60) an operating parameter of the battery on the basis of the determined aging.

6. The method according to one of the preceding claims, comprising:
- determining (S70) a need to replace the battery on the basis of the determined aging.

7. The method according to one of the preceding claims, wherein the time interval is included between one month and one year.

8. The method according to one of the preceding claims, wherein estimating (S30) the states of health comprises:
- identifying, in the obtained tracking, a plurality of calls corresponding to a single call-type profile; and
- estimating the state of health of the battery for each identified call.

9. A computer program comprising instructions for implementing the method of any one of claims 1 to 8 when this program is executed by a processor.

10. A computer-readable nonvolatile recording support on which is recorded a program for implementing the method of any one of claims 1 to 8 when this program is executed by a processor.

11. A processing circuit comprising a processor (100) connected to a nonvolatile recording support (200) according to claim 10.
